# EUROPEAN PATENT APPLICATION

(11) **EP 2 421 027 A2**
(43) Date of publication of application: **22.02.2012**
(21) Application number: 11177851.0
(22) Date of filing: 17.08.2011
(51) Int. Cl.: H01L 21/28, G11C 16/04, H01L 21/265, H01L 29/423, H01L 21/02

(54) **Memory device comprising a polycrystalline-silicon floating gate having impurities therein and manufacturing method thereof**

(30) Priority: 18.08.2010 US 858977
(71) Applicant: NXP B.V., 5656 AG Eindhoven (NL)
(72) Inventor: Van der Vegt, Henderikus Albert, 5656 AG Eindhoven (NL); Dormans, Guido Jozef Maria, 5656 AG Eindhoven (NL); Boter, Johan Dick, 5656 AG Eindhoven (NL); Tao, Guoqiao, 5656 AG Eindhoven (NL)
(74) Representative: Krott, Michel

(57) **Abstract**

Non-volatile floating gate devices and approaches involve setting or maintaining threshold voltage characteristics relative to thermal processing. In connection with various embodiments, a floating gate (210) includes a polycrystalline silicon material having an impurity therein. The impurity interacts with the polycrystalline material to resist changes in grain size of the polycrystalline silicon material during thermal processing, and setting charge storage characteristics relative to threshold voltages for the floating gate device.
The impurity can include a group IV material, nitrogen, oxygen, or carbon.

## Description

Aspects of various embodiments of the present invention are directed to floating gate devices, and in specific embodiments, to non-volatile devices employing floating gates.

Floating gates are used in a variety of semiconductor devices, for many applications. For example, many non-volatile storage devices employ memory cells having a floating gate made of a material such as polycrystalline silicon. These non-volatile memory cells store information by storing electrical charge on the floating gate. The charge stored on the floating gate changes the threshold voltage (Vt) of the memory cell, which controls and/or otherwise determines whether or not current will flow at a specified reading voltage. The threshold voltage is set by storing charge on the floating gate, which can be used to control the flow of current and, accordingly, the readable state of the device.

To distinguish between low and high memory states in floating-gate memory cells (*e.g.*, as applicable to logical values of "zero" and "one" or vice-versa), it is important that the threshold voltages for each of the states are far enough separated such that a reading voltage between the voltages can be used to correctly read out the state of the cell. For example, if the threshold voltages for each of the states "zero" and "one" are too close, it may be difficult to choose a reading voltage between the two states that does not adversely affect the floating gate's ability to maintain the proper state. Accordingly, the distance between a maximum value of a voltage level of a low memory state, and a minimum value of a voltage level of a high memory state, has a bearing upon the robustness of the operation of the memory cell. Achieving these respective high and low memory states with relative threshold voltage levels, for accurately storing memory states and further for providing desirable reading voltages, has been difficult.

These and other matters have presented challenges to the manufacture and implementation of non-volatile devices, including those employing floating gates.

Various example embodiments are directed to non-volatile devices, such as those employing floating gates.

In accordance with an example embodiment, a floating gate memory device is formed as follows. A gate stack is formed to include a polycrystalline silicon floating gate and a control gate that is separated from the floating gate by an inter-gate dielectric. The gate stack is configured to store charge in the polycrystalline silicon floating gate to set threshold voltage characteristics of the memory cell. An impurity is implanted into polycrystalline structure of the polycrystalline silicon floating gate, to interact with the polycrystalline structure and mitigate thermally-induced increases in the grain size of the polycrystalline structure, during thermal processing of the floating gate (*e.g.*, as part of the gate stack formation). The implant is used to maintain the threshold voltage characteristics, as applicable to the entire gate stack, after thermal processing.

In accordance with another example embodiment, a floating gate device includes a substrate having a channel region over which a floating gate is formed, separated from the substrate by a floating gate dielectric material. The floating gate includes polycrystalline silicon material and an impurity configured to interact with the polycrystalline silicon material to resist substantial thermally-induced changes in grain size thereof. A control gate is over the floating gate and separated therefrom by a control gate dielectric.

Another example embodiment is directed to a floating gate stack having a control gate, a polycrystalline silicon floating gate having an impurity therein, and an inter-gate dielectric. The floating gate is configured to store charge to set threshold voltage characteristics of the memory cell, and the impurity (*e.g.*, implanted into polycrystalline structure of the polycrystalline silicon floating gate) interacts with the polycrystalline structure to mitigate thermally-induced increases in the grain size therein, and maintain threshold voltage characteristics of the gate stack.

The above discussion/summary is not intended to describe each embodiment or every implementation of the present disclosure. The figures and detailed description that follow also exemplify various embodiments.

Various example embodiments may be more completely understood in consideration of the following detailed description in connection with the accompanying drawings, in which:
Fig. 1 shows a floating-gate device, in accordance with an example embodiment of the present invention;
Fig. 2 shows a cross-section of a floating-gate layer with impurities implanted therein to resist/mitigate increases in grain size, according to another example embodiment of the present invention;
Fig. 3 shows a plot of threshold voltage ranges for a floating-gate memory device, in accordance with other example embodiments of the present invention; and
Fig. 4 is a flow diagram for a method of manufacturing a floating-gate device, in accordance with another example embodiment of the present invention.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the scope of the invention including aspects defined in the claims.

Aspects of the present invention are believed to be applicable to a variety of different types of non-volatile devices, floating gate devices, and related circuits. While the present invention is not necessarily so limited, various aspects of the invention may be appreciated through a discussion of examples using this context.

According to an example embodiment, the grain size of a floating gate is controlled to mitigate or prevent changes in threshold voltage operation of the floating gate and devices in which the floating gate is employed, as relative to grain size. This increase in grain size is mitigated by implanting an impurity material, such as a carbon-based, nitrogen-based, oxygen-based or group IV-based material (*e.g.*, carbon, germanium and/or silicon) into the floating gate. This implant can be effected after formation of the floating gate, and before and/or during subsequent thermal processing that may subject the floating gate to increases in grain size. This approach can be used, for example, to reduce variation in threshold voltage of floating gate non-volatile devices, as may be relevant to thermal processing.

According to a more particular example embodiment, increases in the grain size of a floating gate during thermal processing are limited or prevented using a carbon-based implant, resulting in smaller final grain sizes in the floating gate at the end of the thermal process relative to such processing as effected without a carbon-based implant. This approach is used to mitigate changes in resulting threshold operation of the floating gate, and accordingly of memory cells in which the gate is employed. For instance, the carbon-based implant can be used to substantially limit grain size increases (*e.g.*, to within about 10%, 20% or 30% of initial grain size), under thermal conditions that would effect polycrystalline silicon grain size increases greater than these values (*e.g*., two or three times the size) absent the implant. In these contexts, thermal processing may involve, for example, various processes exhibiting elevated temperature budgets, such as the deposition of an oxide-nitride-oxide layer as an interpoly dielectric and a sidewall oxidation step, to isolate the floating gate. Similarly, an insubstantial increase in grain size may, for example, be attributed to grain size growth that is less than about 20%, 10% or 5% of initial grain size, depending upon the application.

The floating gate may include one or more of a variety of materials, and the corresponding implant can be tailored to the type of material and the application. In some implementations, a carbon-based species is implanted into polycrystalline silicon that is used as floating gate, with grain size set via deposition or other processes before subsequent thermal processing. The carbon-based species may be implanted using a dosage of between about 1e13 and 1e16 using an energy of between about 5 keV and 50 keV.

Floating gate structures as discussed herein can be implemented with a variety of different types of circuits and devices. For example, floating gate devices can be used with non-volatile memory, as discussed further below. Exemplary memory devices include EPROM, EEPROM and flash memory devices. Other devices include digital-to-analog converters, analog devices, and insulated-gate devices using or benefiting from charge storage characteristics. For memory devices, various embodiments are directed to multi-level memory cells that store multiple bits in the same cell, using an implant approach to obtain tight threshold voltage distribution. For general information regarding memory cells, and for specific information regarding applications to which one or more embodiments may be directed, reference may be made to Nitta, et al., "Three Bits Per Cell Floating Gate NAND Flash Memory Technology for 30nm and beyond," IRPS, p.307-310 (2009), which is fully incorporated herein by reference.

Other embodiments are directed to using an implant to mitigate changes in threshold voltage by limiting mismatches in the electrical behavior of different memory cells (e.g., as due to varying floating gate grain sizes). For general information regarding memory devices, and for specific information regarding mitigation in grain size and applications of the same, reference may be made to Muramatsu et al., "The solution of overerase problem controlling poly-Si grain size- Modified scaling principles for Flash memory," IEDM Tech. Dig, p. 847; Thesis H.P. Tuinhout, ISBN 90 74445 70 5, p. 211-214 (1994), which is fully incorporated herein by reference.

In a more particular implementation, a non-volatile memory cell includes a polycrystalline silicon floating gate with implanted carbon-based material used to mitigate variations in crystalline grain size in the floating gate upon heating. The floating gate is located over a channel region and responds, in connection with a voltage applied to an adjacent control gate, to switch the channel region between conducting states (*e.g.*, conducting and substantially non-conducting).

The polycrystalline silicon floating gate is configured to exhibit, in a pre-thermal processing state, workfunction-based threshold voltage operation with the memory cell in two memory states (low and high) respectively corresponding to charge stored in the floating gate. In one such example, a first memory state may correspond to a high level of stored charge, and a second memory state corresponds to a low level of stored charge. Each of the low and high memory states has a corresponding threshold voltage level, such that a threshold voltage applied to the control gate at (e.g., or above) the level effects switching of the underlying channel region. These low and high states may, for example, correspond to negative and positive charge, or electrons and holes, as stored on the floating gate.

These respective threshold voltages are offset to define a range of voltages in an operational window having a low limit corresponding to the low memory state's threshold voltage level, and a high limit corresponding to the high memory state's threshold voltage level. Accordingly, a reading voltage applied to the control gate and having a value between the low and high limits will switch the channel when the device is in the low memory state, and will not switch the channel when the device is in the high memory state.

In some embodiments, impurities are used to control threshold and reading voltage levels of a floating gate memory cell as follows. In a pre-thermal processing state, the grain size of the floating gate memory cell's workfunction-based threshold voltage operation in low and high memory states respectively corresponds to charge stored in the floating gate. Each of the low and high memory states has a corresponding threshold voltage range, such that a reading voltage applied to the control gate within the range effects switching of the underlying channel region. These respective threshold voltage ranges are offset, such that a highest voltage of the threshold voltage range corresponding to the low memory state is less than a lowest voltage of the threshold voltage range corresponding to the high memory state. An operational window is thus defined as a range of reading voltages between the threshold voltage ranges of these high and low states.

Accordingly, the memory cell functions to read out a memory state by either switching or not switching the channel region in response to the application of the reading voltage to the control gate. The state of the memory cell is controlled by the storage of charge on the floating gate, which can be effected via tunneling from an underlying channel during the application of a voltage across electrodes connected by the channel. An impurity such as a carbon-based material implanted (or otherwise provided) in the floating gate serves to mitigate or prevent changes in grain size of the polycrystalline silicon, and thus mitigates or prevents changes in the threshold voltage levels corresponding to each of the low and high memory states in order to maintain the operational voltage range. These approaches may, for example, be used in conjunction with approaches for separating the average threshold voltages of both states and by limiting or minimizing the spread around these average values in each state. The average values can be changed by applying more or less charge on the floating gate, with separation achieved relative to cell size and program/erase speed.

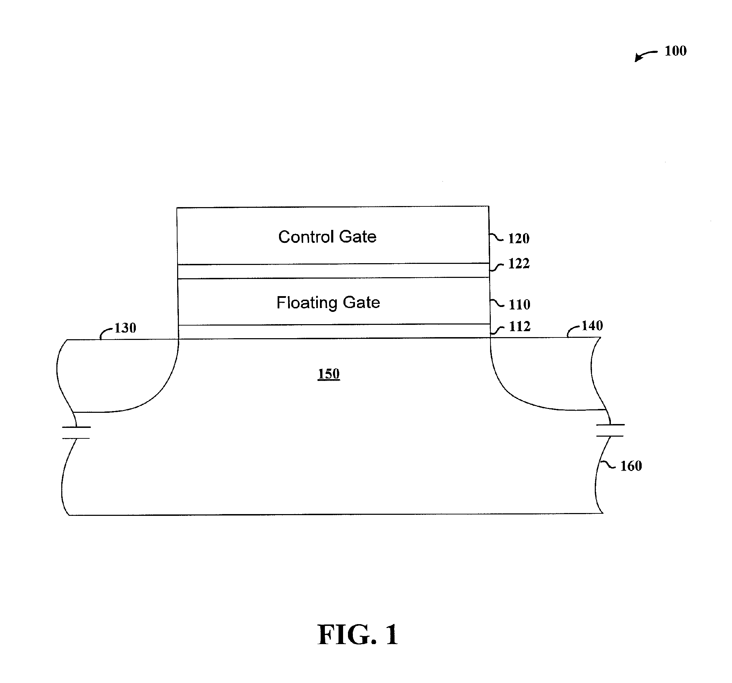

Turning now to the figures, Figure 1 shows a floating-gate device 100, in accordance with another example embodiment of the present invention. The device includes a floating gate 110 on a floating gate dielectric 112, and a control gate 120 on a control gate dielectric 122 (*e.g.*, an inter-gate dielectric) that separates the control gate from the floating gate. Active region electrodes 130 and 140 (*e.g.*, source and drain electrodes) are separated by a channel region 150 below the floating gate dielectric 112.

During thermal processing, the grain size of the material used to form the floating gate 110 is controlled to mitigate or prevent changes in threshold voltage operation of the device, in a manner as discussed above. For example and in connection with a particular example embodiment, the floating gate 110 includes a crystalline structure and an impurity material such as carbon that acts against tendencies of the crystalline structure to grow in grain size during thermal processing. This implant in the floating gate 110 reduces variation in threshold voltage of the device 100, such as by interacting with the crystalline structure to mitigate or prevent changes therein as relevant to grain size and otherwise (*e.g.*, the presence of the impurity within the crystalline structure can be used to resist changes of the crystalline structure).

The device floating gate device 100 is shown formed on a substrate 160, in which the electrodes 130 and 140, as well as the channel 150, are formed. The device 100 may be implemented as a stand-alone device or as part of an integrated circuit having several such devices on the substrate. For example, devices such as shown may be arranged in the form of a memory array or any other relevant arrangement to suit particular applications. Other devices or circuits, such as those involving other interconnected and/or separate circuits, may also be formed on the substrate 160 to suit particular applications.

The respective components of the device 100 as shown may include one or more of a variety of types of materials, and may include sub-layers within. For instance, the floating gate dielectric 112 may include two or more layers, respectively making up the dielectric (and of which, one or more layers may be a non-dielectric material). Similarly, one or both of the floating gate and gate may include different types of materials, such as different growth-inhibiting impurities, which can be mixed, layered or otherwise appropriately arranged to suit particular applications.

The gate stack including the floating gate 110, floating gate dielectric 112, control gate 120 and control gate dielectric 122 can be used in a variety of devices that may include components different than the electrodes 130 and 140, and/or different than the channel 150. A variety of insulated gate devices can thus be formed using the gate stack as shown, to suit different applications. For instance, the stack can be used as part of a transistor circuit, a digital-to-analog converter (DAC) circuit, digital storage circuit, neural computational circuit, or non-volatile memory such as EEPROM.

The device 100 can be operated in one or more of a variety of manners. In some applications, charge is stored on the floating gate 110 via tunneling through the floating gate dielectric 112, during application of a voltage across the control gate 120 and channel 150. The stored charge can be erased via the application of an erasing voltage, other connected circuits, or other charge-dissipating approach such as those involving the use of light. The device 100 is configured to operate to conduct current between the electrodes 130 and 140 via the channel region 150, in response to different threshold voltages applied to the control gate, depending upon the charge stored in the floating gate 110. This threshold voltage is also controlled via the impurity or impurities in the floating gate 110, which mitigate or prevent increases in grain size of the floating gate during thermal processing as discussed above. Accordingly, by storing and erasing charge as discussed above, the memory state of the device 100 is set.

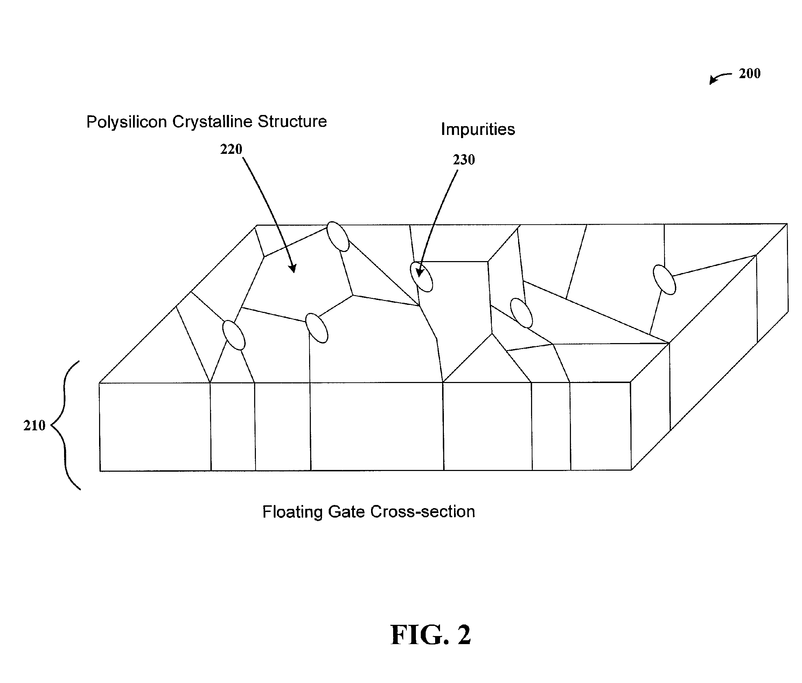

Fig. 2 shows a cross-section 200 of a floating gate layer 210, with impurities implanted in the floating gate layer to resist/mitigate increases in grain size, according to another example embodiment of the present invention. The cross-section 200 can be implemented as part of a much larger area, with additional polycrystalline silicon grains and/or impurities therein as discussed further below. The floating gate layer 210 may also be implemented with a variety of devices, such as the floating gate device 100 as shown in Figure 1, as (or part of) the floating gate 210. In addition, while shown in a relatively planar form, structure as shown in the floating gate layer 210 by way of example can be used in a variety of different forms and shapes, to suit particular applications.

The floating gate layer 210 includes polycrystalline silicon having a crystalline structure including grains as represented at 220, respectively interfacing with one another. These grains are susceptible to growth and related changes in threshold voltage, such as via combination or otherwise, in response to heat as may be applicable, for example, to thermal processing in excess of 500 °C, 600 °C or 700 °C. To mitigate this growth, impurities as represented by impurity 230 are provided in the floating gate layer 210, and act to slow or prevent growth of the polycrystalline silicon grains (220) in floating gate layer.

The impurities as represented by 230 may be formed in one or more of a variety of manners. For example, while a few impurities are shown, various embodiments involve using a multitude of impurities in the floating gate layer 210, such as to include impurities at interfaces of a majority of the grains. Other embodiments involve using fewer impurities. Still other embodiments involve using different sizes of impurities, which may be larger and/or smaller than that shown.

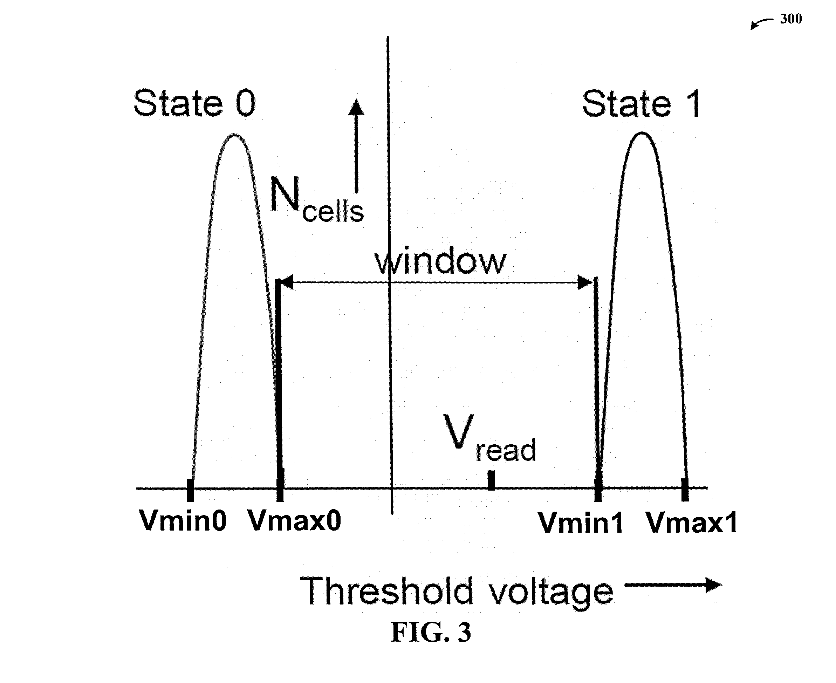

Fig. 3 shows a plot 300 of threshold voltage ranges for a floating gate memory device, in accordance with other example embodiments of the present invention. The plot 300 shows two memory states "0" and "1" of a floating gate device, respectively corresponding to different levels of stored charge in a floating gate. These states as shown are exemplary, and may be flipped with the high threshold state being implemented as a logical "0" and the low threshold state being implemented as a logical "1." Accordingly, while the following discussion of exemplary embodiments involving Figure 3 is based upon states "0" and "1" respectively corresponding to the lower and higher threshold voltage states of the floating gate memory device, the embodiments may also be applicable to the "0" being high and "1" being low.

Each of the states exhibits a corresponding threshold voltage range having lower (*e.g.*, minimum) and higher (*e.g.*, maximum) voltage levels. The logical "0" state exhibits a threshold voltage range between Vmin0 and Vmax0, while the logical "1" state exhibits a threshold voltage range between Vmin1 and Vmax1. The operating window of the floating gate memory device is thus set as a voltage range between Vmax0 and Vmin1.

Where the low and high memory states respectively correspond to logical "0" and "1" states of the floating-gate memory cell, the threshold voltages for each of the states are thus maintained separated far enough from one another such that a reading voltage in between the voltages can be used to correctly read out the state of the cell, without venturing too close to the threshold voltage levels of either the high or low states. For example, if the threshold voltages for each of the states "0" and "1" are too close, it may be difficult to choose a reading voltage between the two states that does not adversely affect the floating gate's ability to maintain the proper state. Accordingly, to prevent errors in reading the cell, the maximum value of the low threshold voltage state (Vmax0) and the minimum value of the high threshold voltage state (Vmin1) are set relative to one another to establish an operating window that is sufficient to permit the application of a read voltage (Vread) to the control gate, without inadvertently causing the memory cell to switch. In this context, the term "sufficient" generally refers to an operating window corresponding to a range of voltages that will not cause the cell to switch.

In accordance with various embodiments applicable to a floating gate memory cell with operational characteristics corresponding to those shown in Figure 3, a polycrystalline silicon floating gate of the memory cell includes impurities that set/maintain the operating window between threshold voltage states substantially as shown. Relative to grain size, the impurities thus mitigate the growth of the grains during thermal processing, to maintain characteristics of the floating gate to facilitate the operation within an acceptable range as relative to operation of the floating gate, absent thermal processing. In various implementations, the impurities work to substantially maintain the respective threshold voltage ranges and/or resulting operating window within about 50%, 20%, 10% or 5% of such ranges as would be exhibited, absent thermal processing.

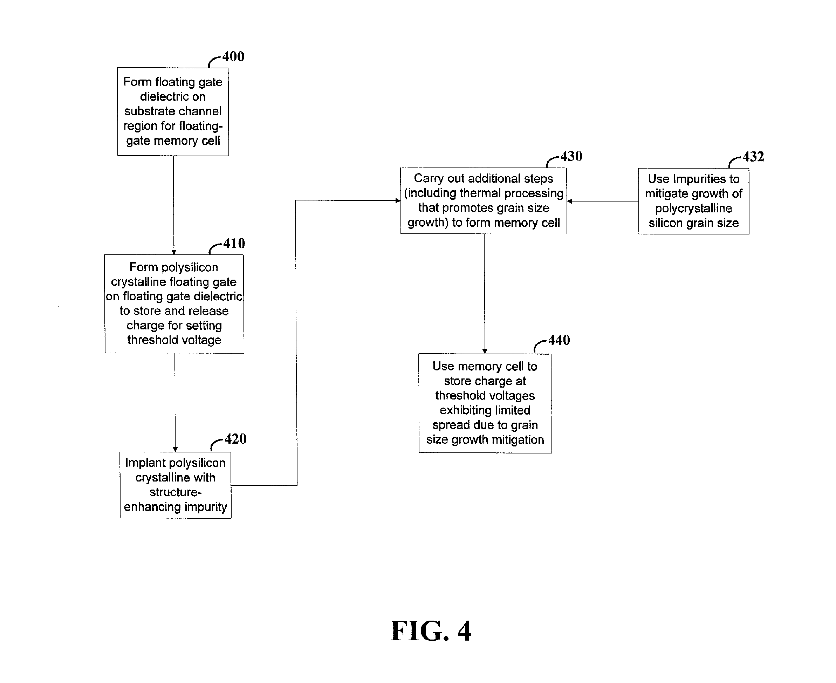

Fig. 4 is a flow diagram for a method of manufacturing a floating gate memory cell, in accordance with another example embodiment of the present invention. At block 400, a floating gate dielectric is formed on a substrate channel region of a floating gate memory cell. A polycrystalline silicon floating gate is formed on the floating gate dielectric at block 410, and the polycrystalline silicon is implanted with a structure-enhancing impurity at block 420. At block 430, additional processing steps, including thermal processing steps that promote grain size growth in polycrystalline silicon, are carried out to form the memory cell (*e.g.*, to complete and connect the cell).

During the thermal processing steps at block 430, the impurities are used as shown at block 432 to mitigate the growth of grain sizes in the polycrystalline silicon as the memory cell is exposed to thermal processing (*e.g.,* heated). This growth mitigation is used to set, or maintain, characteristics of the polycrystalline silicon that affect the threshold voltage operation of the floating gate in high and low memory states, and also to maintain a voltage range window between these states for a reading voltage, such as discussed above with Figure 3. At block 440, the memory cell is used to store charge at threshold voltages exhibiting limited spread due to the mitigation of grain size growth, correspondingly setting a logical state of the memory cell that can be read using a reading voltage between the threshold voltage levels.

Based upon the above discussion and illustrations, those skilled in the art will readily recognize that various modifications and changes may be made to the present invention without strictly following the exemplary embodiments and applications illustrated and described herein. For example, the described floating gate structures may be implemented with other floating gate devices, as well as many circuits and devices employing floating gate devices. Different materials may be used for the floating gate, with an implant material used to inhibit grain size increases and corresponding changes in electrical properties, such as threshold voltage levels. In addition, grain size control as discussed can be implemented using different approaches, or to different applications that may go beyond, or operate as an alternative to, floating gate devices. Such modifications do not depart from the true spirit and scope of the present invention, including that set forth in the following claims.

## Claims

1. A floating gate device comprising:
a substrate having a channel region;
a floating gate dielectric material over the channel region;
a floating gate on the floating gate dielectric material and including
polycrystalline silicon material, and
an impurity in the polycrystalline silicon material and configured to interact with the polycrystalline silicon material to resist substantial thermally-induced changes in grain size of the polycrystalline silicon material;
a control gate dielectric on the floating gate; and
a control gate on the control gate dielectric.

2. The device of claim 1, wherein the impurity is configured to interact with the polycrystalline material to resist substantial thermally-induced changes in grain size of the polycrystalline silicon material that are due to heating of the polycrystalline structure to a temperature at which the grain size of the polycrystalline silicon structure would substantially increase, absent the impurity.

3. The device of claim 1, wherein
the polycrystalline silicon material is susceptible to grain size growth and corresponding changes in threshold voltage characteristics during heating to a threshold temperature, and
the impurity in the polycrystalline silicon material is configured to, during heating of the polycrystalline silicon material to the threshold temperature, mitigate grain size growth of the polycrystalline silicon material to maintain the threshold voltage characteristics of the polycrystalline silicon material.

4. The device of claim 1, wherein the floating gate is configured to operate in a first memory state in which a high level of charge is stored in the floating gate, and to operate in a second memory state in which a lower level of charge is stored in the floating gate, the impurity being configured to resist changes in grain size of the polycrystalline silicon material and maintain the charge-storing characteristics of the polycrystalline silicon material for the respective memory states.

5. The device of claim 1, wherein
the floating gate is configured to operate in a first memory state in which a high level of charge is stored in the floating gate, and to operate in a second memory state in which a lower level of charge is stored in the floating gate,
the first memory state is **characterized by** a high threshold voltage, with the control gate and floating gate configured to apply a bias to switch the channel into a conducting state in response to a voltage at least as high as the high threshold voltage applied to the control gate,
the second memory state is **characterized by** a low threshold voltage, with the control gate and floating gate configured to apply a bias to switch the channel into a conducting state in response to a voltage at least as high as the low threshold voltage applied to the control gate, and
the floating gate being configured, via the impurity, to resist grain size growth during thermal processing to maintain a difference between the high and low threshold voltages that is sufficient to permit the application of a reading voltage to the control gate that
switches the channel into a conducting state when the floating gate is in the second memory state, and
does not switch the channel into a conducting state when the floating gate is in the first memory state.

6. The device of claim 5, wherein the impurity and polycrystalline silicon in the floating gate are configured to resist grain size growth of the polycrystalline silicon during thermal processing to maintain a difference between the high and low threshold voltages after thermal processing that is sufficient to permit the application of a range of reading voltages to the control gate that switches the channel into a conducting state when the floating gate is in the second memory state but does not switch the channel into a conducting state when the floating gate is in the first memory state, the difference between lowest and highest voltage values in the range of reading voltages being at least half as great as the difference between the high and low threshold voltages.

7. The device of claim 5, wherein the impurity and polycrystalline silicon are configured to substantially maintain the difference between the high and low threshold voltages during and after heating of the polycrystalline structure to a thermal processing temperature at which the grain size of the polycrystalline silicon structure would increase, absent the impurity.

8. The device of claim 1, wherein the impurity includes at least one of: a group IV material, nitrogen and oxygen.

9. The device of claim 1, wherein the impurity is carbon.

10. A floating gate stack comprising:
a control gate;
a polycrystalline silicon floating gate configured to store charge to set threshold voltage characteristics of the memory cell;
an inter-gate dielectric between the control gate and the polycrystalline silicon floating gate; and
an impurity implanted into polycrystalline structure of the polycrystalline silicon floating gate, the impurity being configured to, while the gate stack is exposed to thermal processing, interact with the polycrystalline structure and mitigate thermally-induced increases in the grain size of the polycrystalline structure, and maintain the threshold voltage characteristics.

11. A method for forming a floating gate memory device, the method comprising:
forming a gate stack including a polycrystalline silicon floating gate and a control gate that is separated from the floating gate by an inter-gate dielectric, the gate stack being configured to store charge in the polycrystalline silicon floating gate to set threshold voltage characteristics of the memory cell;
introducing an impurity into polycrystalline structure of the polycrystalline silicon floating gate; and
exposing the polycrystalline silicon floating gate to thermal processing and using the implanted impurity to interact with the polycrystalline structure and mitigate thermally-induced increases in the grain size of the polycrystalline structure, and maintain the threshold voltage characteristics.

12. The method of claim 11, wherein the step of exposing the polycrystalline silicon floating gate to thermal processing is carried out as part of the step of forming the gate stack.

13. The method of claim 11, wherein
forming a gate stack includes forming a polycrystalline silicon floating gate configured to store charge for operation of the gate stack at a high-level threshold voltage range, and to release charge for operation of the gate stack at a low-level threshold voltage range, the respective threshold voltage ranges corresponding to memory states of the memory device, and
using the implanted impurity to interact with the polycrystalline structure and maintain the threshold voltage characteristics includes using the implanted impurity to interact with the polycrystalline silicon structure to maintain a difference in voltage between a highest voltage of the low-level threshold voltage range, and a lowest voltage of the high-level threshold voltage range.

14. The method of claim 11, wherein processing the polycrystalline silicon floating gate under heating conditions includes annealing the polycrystalline silicon floating gate at a temperature that would effect a substantial increase in grain size of the polycrystalline silicon structure, absent the implanted impurity.

15. The method of claim 11, wherein
forming a gate stack includes forming the floating gate to operate in a first memory state in which a high level of charge is stored in the floating gate, and to operate in a second memory state in which a lower level of charge is stored in the floating gate, and
implanting an impurity into polycrystalline structure of the polycrystalline silicon floating gate includes implanting an impurity configured to resist changes in grain size of the polycrystalline silicon material and maintain the charge-storing characteristics of the polycrystalline silicon material for the respective memory states.

16. The method of claim 15, wherein
forming a gate stack includes
forming the gate stack to operate in a first memory state **characterized by** a high threshold voltage, by configuring the control gate and floating gate to apply a bias to switch the channel into a conducting state in response to a voltage at least as high as the high threshold voltage applied to the control gate, and
forming the gate stack to operate in a second memory state **characterized by** a low threshold voltage, by configuring control gate and floating gate to apply a bias to switch the channel into a conducting state in response to a voltage at least as high as the low threshold voltage applied to the control gate, and
exposing the polycrystalline silicon floating gate to thermal processing includes using the implanted impurity to resist grain size growth to maintain a difference between the high and low threshold voltages that is sufficient to permit the subsequent application of a reading voltage to the control gate that
switches the channel into a conducting state when the floating gate is in the second memory state, and
does not switch the channel into a conducting state when the floating gate is in the first memory state.

17. The method of claim 16, wherein implanting an impurity includes configuring the polycrystalline silicon in the floating gate with the impurity to resist grain size growth of the polycrystalline silicon during thermal processing to maintain a difference between the high and low threshold voltages after thermal processing that is sufficient to permit the application of a range of reading voltages to the control gate that switches the channel into a conducting state when the floating gate is in the second memory state but does not switch the channel into a conducting state when the floating gate is in the first memory state, the difference between lowest and highest voltage values in the range of reading voltages being at least half as great as the difference between the high and low threshold voltages.

18. The method of claim 16, wherein implanting an impurity includes configuring the polycrystalline silicon in the floating gate with the impurity to substantially maintain the difference between the high and low threshold voltages during and after heating of the polycrystalline structure to a thermal processing temperature at which the grain size of the polycrystalline silicon structure would substantially increase, absent the impurity.

19. The method of claim 11, wherein implanting an impurity includes implanting at least one of: a group IV material, nitrogen and oxygen.

20. The method of claim 11, wherein implanting an impurity includes implanting carbon.
